# EUROPÄISCHE PATENTSCHRIFT

(11) **EP 1 199 857 B1**
(45) Veröffentlichungstag und Bekanntmachung des Hinweises auf die Patenterteilung: **31.10.2007**
(21) Anmeldenummer: 01121602.5
(22) Anmeldetag: 11.09.2001
(51) Int. Cl.: H04L 25/02, H03K 19/0175, G06F 13/40

(54) **Tri-State-Treiberanordnung**
Tristate driver
Circuit d'attaque à trois états

(30) Priorität: 21.09.2000 DE 10046806
(43) Veröffentlichungstag der Anmeldung: 24.04.2002
(73) Patentinhaber: Infineon Technologies AG, 81669 München (DE)
(72) Erfinder: Strzalkowski, Bernhard, 81377 München (DE)
(74) Vertreter: Banzer, Hans-Jörg

(56) Entgegenhaltungen:
- EP-A- 0 875 995
- EP-A- 0 962 869
- WO-A-99/21332
- DE-U1- 20 021 547

## Beschreibung

Die vorliegende Erfindung betrifft eine Tri-State-Treiberanordnung nach dem Oberbegriff des Anspruches 1, insbesondere eine Tri-State-Treiberanordnung, welche in einer Schnittstelle, beispielsweise gemäß der RS-485-Norm, zum Senden von Daten eines Teilnehmers über einen Kommunikationsbus an einen weiteren Teilnehmer verwendet werden kann.

Die RS-485-Norm dient zur Definition der Informationsübertragung über unterschiedliche Kommunikationsbusse. Der Kommunikationsbus besteht dabei aus einer Zwei-Draht-Leitung, an der die einzelnen Busteilnehmer parallel angeschlossen sind, wobei mehrere Busteilnehmer gleichzeitig die von einem anderen Busteilnehmer gesendeten Daten empfangen können (sog. "Multidrop"-Konfiguration). Wegen der hohen Anzahl der Knotenpunkte und der Anforderung einer sicheren Daten- bzw. Signalübertragung sind alle Busteilnehmer von dem Kommunikationsbus potentialgetrennt. Des Weiteren müssen die den einzelnen Busteilnehmern zugeordneten Leitungs- oder Ausgangstreiber die Tri-State-Eigenschaft besitzen, d.h. neben den Zuständen "L" und "H" noch einen dritten, hochohmigen Zustand annehmen können. Ist ein Busteilnehmer aktiv, d.h. sendet der diesem Busteilnehmer zugeordnete Ausgangstreiber Daten, müssen sich alle anderen Busteilnehmer im Empfangsmodus befinden und ihren Ausgangstreiber von dem Kommunikationsbus trennen, d.h. in den erwähnten Tri-State-Zustand schalten.

In Figur 5 ist ein Beispiel für eine potentialgetrennte RS-485-Schnittstelle gemäß dem Stand der Technik dargestellt. Die RS-485-Schnittstelle umfasst einen als Sender dienenden Tri-State-Treiber 12 mit einem Ausgangstreiber 16, welcher mit einer Zwei-Draht-Busleitung A, B verbunden ist. Dem Tri-State-Treiber 12 werden Sendedaten TxD zugeführt und mit einem Verstärker 14 verstärkt. Ein schneller Optokoppler 15 überträgt die Sendedaten potentialgetrennt an den Ausgangstreiber 16. Des Weiteren wird dem Tri-State-Treiber 12 ein Aktivierungs- oder Freigabesignal EN zugeführt und von einem Verstärker 17 verstärkt. Ein langsamer Optokoppler 18 überträgt das Freigabesignal über einen weiteren Verstärker 19 potentialgetrennt in Form einer entsprechenden Spannung U_{EN1} an den Ausgangstreiber 16, wobei der Ausgangstreiber 16 in Abhängigkeit von dem Spannungswert U_{EN1} aktiviert oder deaktiviert wird, d.h. in den Tri-State-Zustand geschaltet wird. Des Weiteren umfasst die RS-485-Schnittstelle einen Empfänger 13, welcher ebenfalls mit der Zwei-Draht-Busleitung A, B verbunden ist, wobei ein Verstärker 20 die von einem anderen Teilnehmer gesendeten Daten empfängt und verstärkt und mit einem weiteren schnellen Optokoppler 21 über einen Treiber 22 als Empfangsdaten RxD ausgegeben werden.

Wie aus Figur 5 ersichtlich ist, benötigt die RS-485-Schnittstelle bzw. der entsprechende Tri-State-Treiber 12 zum Senden der Sendedaten der TxD sowie zum Aktivieren/Deaktivieren des Ausgangstreibers 16 zwei Kanäle mit jeweils einem Optokoppler, d.h. die Anzahl der benötigten Bauteile sowie die benötigte Ansteuerleistung ist relativ hoch.

Aus der EP 0 962 869 A1 ist eine Tri-State-Treiberanordung mit den Merkmalen des Obergriffs des Anspruches 1 bekannt, wobei als Koppler für potenzialgetrennten Signalübertragung zwischen dem Eingang und dem Ausgang der Tri-State-Treiberanordnung ein Oktokoppler zur Anwendung kommt.

Darüber hinaus ist aus der WO 99/21332 A1 eine Treiberschaltung bekannt, bei welcher zur potenzialgetrennten Signalübertragung ein Magnetkoppler verwendet wird.

Der vorliegenden Erfindung liegt die Aufgabe zu Grunde, eine Tri-State-Treiberanordnung bereitzustellen, die mit geringerem Ansteueraufwand eine potentialgetrennte Signalübertragung ermöglicht.

Diese Aufgabe wird erfindungsgemäß durch eine Tri-State-Treiberanordnung mit den Merkmalen des Anspruches 1 gelöst. Die Unteransprüche definieren jeweils bevorzugte und vorteilhafte Ausführungsformen der vorliegenden Erfindung.

Die erfindungsgemäße Tri-State-Treiberanordnung verwendet als Koppler zur potentialgetrennten Signalübertragung zwischen dem Eingang und dem Ausgang der Tri-State-Treiberanordnung einen Magnetkoppler, welcher insbesondere durch einen auf Grundlage des sogenannten GMR("Giant Magnet Resistor")-Effekts arbeitenden Sensor gebildet sein kann. Ebenso können jedoch auch andere Arten von Magnetkopplern, wie z.B. Hall-Sensoren, Signaltransformatoren etc., eingesetzt werden.

Durch die Verwendung des Magnetkopplers ist für das Senden von Informationen oder Daten sowie für das Aktivieren/Deaktivieren des Ausgangstreibers der Tri-State-Treiberanordnung lediglich ein Kanal erforderlich. Dies bedeutet gegenüber dem eingangs beschriebenen Stand der Technik ein Ersparnis von Bauteilen und Ansteuerleistung. Des Weiteren erlaubt die Verwendung des Magnetkopplers eine Einsparung der benötigten Siliziumfläche sowie des Bondaufwands bei Verwendung der erfindungsgemäßen Tri-State-Treiberanordnung in einer potentialgetrennten RS-485-Schnittstelle und Integration dieser potentialgetrennten RS-485-Schnittstelle in ein Gehäuse.

Zudem wird im Rahmen der vorliegenden Erfindung eine geeignete Logik oder Steuerung vorgeschlagen, welche das von dem Koppler gelieferte Ausgangssignal, insbesondere die von dem Koppler gelieferte Ausgangsspannung, hinsichtlich eines vordefinierten Grenzbereichs auswertet und davon abhängig ein Aktivierungs- oder Freigabesignal für den Ausgangstreiber erzeugt, um diesen zum Senden von Daten zu aktivieren oder zu deaktivieren, d.h. in den hochohmigen Tri-State-Zustand zu schalten. Dabei ist es besonders vorteilhaft, wenn das erwähnte Freigabesignal über einen Glättungsfilter mit einer entsprechenden Zeitkonstante dem Ausgangstreiber zugeführt wird, um den Ausgangstreiber nicht unnötig für kurze Zeitintervalle abzuschalten. Die im Rahmen der vorliegenden Erfindung vorgeschlagene Vorgehensweise zur Auswertung des Ausgangssignals des Kopplers, um davon abhängig den Ausgangstreiber zum Senden von Daten zu aktivieren bzw. in den Tri-State-Zustand zu schalten und somit zu deaktivieren, ist besonders einfach und aufwandsarm realisierbar und im Prinzip von der Art des jeweils verwendeten Kopplers unabhängig, solange dieser eine ausreichend lineare Ausgangskennlinie aufweist, welche die erfindungsgemäße Auswertung des Ausgangssignals des Kopplers ermöglicht.

Die vorliegende Erfindung eignet sich insbesondere zum Einsatz in potentialgetrennten RS-485-Schnittstellen. Selbstverständlich kann die vorliegende Erfindung jedoch überall dort eingesetzt werden, wo eine potentialgetrennte Signal- oder Datenübertragung zwischen einem Eingang und einem Ausgang mit Tri-State-Eigenschaft gewünscht ist.

Die vorliegende Erfindung wird nachfolgend anhand bevorzugter Ausführungsbeispiele unter Bezugnahme auf die beigefügte Zeichnung näher erläutert.
Figur 1 zeigt den prinzipiellen Aufbau einer Tri-State-Treiberanordnung gemäß einem bevorzugten Ausführungsbeispiel der vorliegenden Erfindung,
Figur 2 zeigt eine Strom/Spannungskennlinie eines in Figur 1 verwendeten quasi-linearen Magnetkopplers,
Figur 3 zeigt Signalverläufe zur Erläuterung der Funktionsweise der in Figur 1 dargestellten Tri-State-Treiberanordnung,
Figur 4A und Figur 4B zeigen Ausführungsbeispiele für die Integration der erfindungsgemäßen Tri-State-Treiberanordnung in ein Gehäuse in Form einer Zwei-Chip-Lösung bzw. Ein-Chip-Lösung, und
Figur 5 zeigt den beispielhaften Aufbau einer RS-485-Schnittstelle mit einer Tri-State-Treiberanordnung gemäß dem Stand der Technik.

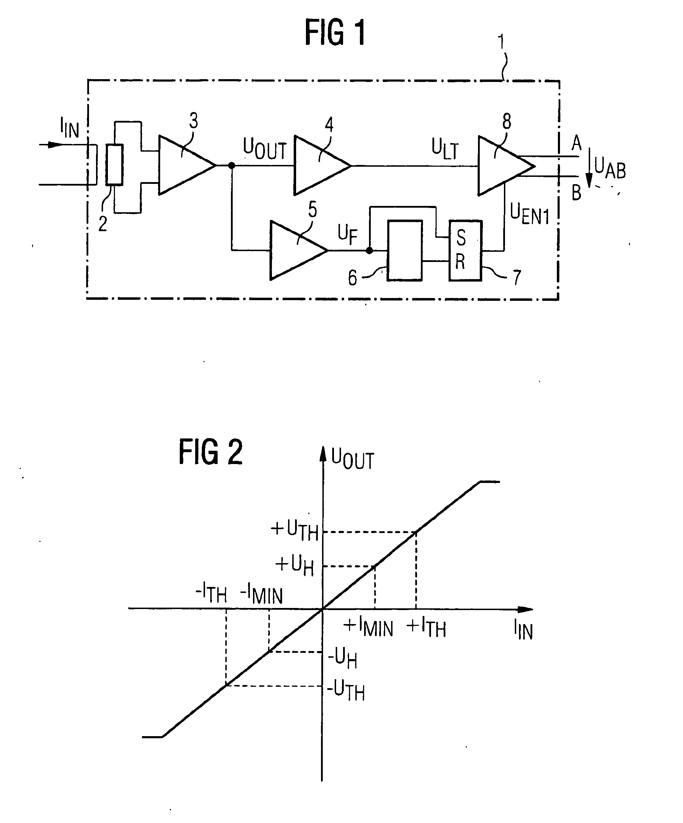

Die in Figur 1 dargestellte Tri-State-Treiberanordnung 1 weist einen Eingang auf, dem ein Eingangsstrom I_{IN} zugeführt wird. Des Weiteren weist die Tri-State-Treiberanordnung einen Ausgang auf, der beispielsweise an eine Zwei-Draht-Busleitung A, B anzuschließen ist. Die Signalübertragung zwischen dem Eingang und dem Ausgang der Tri-State-Treiberanordnung erfolgt potentialgetrennt. Zu diesem Zweck ist ein Magnetkoppler 2 vorgesehen, dessen Ausgangsspannung von einem Verstärker 3 verstärkt und von einem ersten Komparator 4 ausgewertet wird, um einen Leitungs- oder Ausgangstreiber 8 entsprechend anzusteuern. Des Weiteren ist ein zweiter Komparator 5 vorgesehen, welcher ebenfalls die von dem Verstärker 3 gelieferte Ausgangsspannung U_{OUT} auswertet und davon abhängig ein entsprechendes Ausgangssignal U_{F} erzeugt, welches mit Hilfe eines Glättungsfilters 6 und eines Flip-Flops 7 in ein Aktivierungs- oder Freigabesignal U_{EN1} für den Ausgangstreiber 8 umgesetzt wird.

Bei dem Magnetkoppler 2 kann es sich insbesondere um einen gemäß dem sogenannten GMR("Giant Magnet Ressistor")-Effekt arbeitenden Sensor handeln, welcher die infolge des Eingangsstroms I_{IN} hervorgerufene Veränderung der Magnetfeldrichtung erfasst und davon abhängig eine entsprechende Ausgangsspannung U_{OUT} liefert. Dabei kann der Magnetkoppler 2 insbesondere eine quasi-lineare Übertragungskennlinie der in Figur 2 dargestellten Art aufweisen. Die Stabilität und die Hysteresebreite der Kennlinie spielen jedoch für die vorliegende Erfindung keine große Rolle. Von Bedeutung ist jedoch, dass bei dem Eingangsstrom I_{IN}=0 eine Ausgangsspannung U_{OUT} im Bereich -U_{TH}...+U_{TH} erzeugt wird.

Die Funktionsweise der in Figur 1 gezeigten Tri-State-Treiberanordnung ist wie folgt.

Wie bereits erwähnt worden ist, wird die Ausgangsspannung U_{OUT} des Magnetkopplers 2 bzw. des Verstärkers 3 von dem in Figur 1 dargestellten Komparator 5 ausgewertet bzw. überwacht. Dabei kann es sich insbesondere um einen Fenster-Komparator handeln, welcher die Ausgangsspannung U_{OUT} hinsichtlich des unteren Grenzwerts -U_{TH} und des oberen Grenzwerts +U_{TH}, d.h. den Eingangsstrom I_{IN} hinsichtlich des unteren Grenzwerts -I_{TH} und des oberen Grenzwerts +I_{TH}, überwacht. Stellt der Komparator 5 fest, dass die Ausgangsspannung U_{OUT} in dem Bereich - U_{TH} ...+U_{TH}, d.h. der Eingangsstrom I_{IN} im Bereich -I_{TH}...+I_{TH}, liegt, erkennt der Komparator 5 den stromlosen Zustand am Eingang der Tri-State-Treiberanordnung und erzeugt daraufhin eine Ausgangsspannung U_{F}, welche über den Rücksetzeingang R des Flip-Flops 7 das an den Tri-State-Eingang des Ausgangstreibers 8 anliegende Freigabesignal U_{EN1} auf den niedrigen Pegel "L" setzt und somit den Ausgangstreiber 8 deaktiviert, d.h. in den hochohmigen Tri-State-Zustand schaltet. Befindet sich der Ausgangstreiber 8 in dem Tri-State-Zustand, ist die Tri-State-Treiberanordnung 1 auf Grund des gesperrten Ausgangs des Ausgangstreibers 8 von der Zwei-Draht-Busleitung A, B getrennt und kann somit keine Daten mehr senden. Erkennt hingegen der Komparator 5, dass die Ausgangsspannung U_{OUT} des Magnetkopplers 2 kleiner als -U_{TH} oder größer als +U_{TH} ist, d.h. dass der Eingangsstrom I_{IN} kleiner als -I_{TH} oder größer als +I_{TH} ist, wird über den Setzeingang S des Flip-Flops 7 das Freigabesignal U_{EN1} auf den hohen Pegel "H" gesetzt und somit der Ausgangstreiber 8 aktiviert, so dass über den Ausgangstreiber 8 Daten über die Zwei-Draht-Busleitung A, B übertragen werden können.

Wie ebenfalls bereits erwähnt worden ist, überwacht auch der Komparator 4 die Ausgangsspannung U_{OUT} des Magnetkopplers 2. Auch bei diesem Komparator 4 kann es sich um einen Fenster-Komparator handeln, wobei der Komparator 4 jedoch die Ausgangsspannung U_{OUT} des Magnetkopplers 2 hinsichtlich der in Figur 2 gezeigten Grenzen -U_{H} und +U_{H}, d.h. den Eingangsstrom I_{IN} hinsichtlich -I_{MIN} und +I_{MIN}, überwacht. Unterschreitet die Ausgangsspannung U_{OUT} des Magnetkopplers 2 den unteren Grenzwert -U_{H}, d.h. unterschreitet der Eingangsstrom I_{IN} den unteren Grenzwert -I_{MIN}, erkennt der Komparator 4 den "Low"-Zustand -U_{H} und setzt die am Signaleingang des Ausgangstreibers 8 anliegende Eingangsspannung U_{LT} auf den niedrigen Pegel U_{LT}="L", d.h. auf den logischen Wert U_{LT}="O". Überschreitet hingegen die Ausgangsspannung U_{OUT} den Grenzwert +U_{H}, d.h. überschreitet der Eingangsstrom I_{IN} den Grenzwert +I_{MIN}, erkennt der Komparator 4 den "High"-Zustand +U_{H} und setzt die Eingangsspannung U_{LT} des Ausgangstreibers 8 auf den hohen Pegel "H", d.h. auf den logischen Wert U_{LT}="1". Der Ausgangstreiber 8 erzeugt daraufhin eine der Eingangsspannung U_{LT} entsprechende Ausgangsspannung U_{AB}, um die dem Eingangsstrom I_{IN} bzw. der Ausgangsspannung U_{OUT} entsprechenden Daten oder Informationen über die Zwei-Draht-Busleitung A, B zu übertragen.

Der Komparator 4 ist somit im Sendepfad der Tri-State-Treiberanordnung 1 angeordnet, während der Komparator 5 in dem Tri-State-Pfad zur Aktivierung oder Deaktivierung des Tri-State-Zustands des Ausgangstreibers 8 angeordnet ist.

Während des Sendens von Daten durchschreitet der Eingangsstrom I_{IN} in der Regel mehrfach den Bereich -I_{TH} ... +I_{TH}. Um den Ausgangstreiber 8 nicht unnötig für kurze Zeitintervalle abzuschalten, ist dem Rücksetzeingang R des Flip-Flops 7 ein Glättungsfilter 6 vorgeschaltet, dessen Zeitkonstante derart dimensioniert ist, dass kurze Impulse der Ausgangsspannung U_{F} des Komparators 5, welche beispielsweise lediglich eine Dauer von 5 bis 10 ns aufweisen, nicht zur Deaktivierung des Ausgangstreibers 8 führen. Zu diesem Zweck kann die Zeitkonstante des Glättungsfilters 6 beispielsweise zwischen 50 ns und 100 ns liegen.

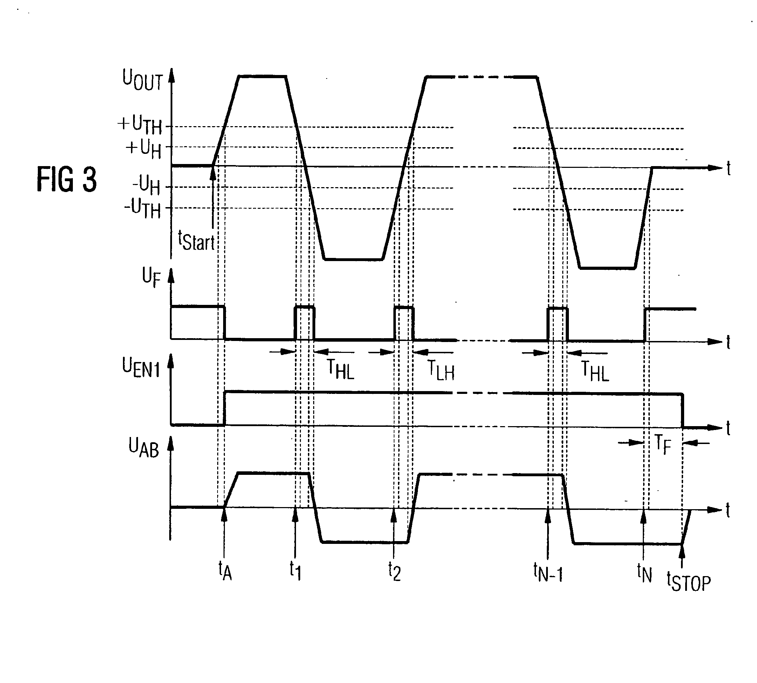

Die zuvor beschriebene Funktionsweise der in Figur 1 dargestellten Tri-State-Treiberanordnung wird auch anhand der in Figur 3 dargestellten beispielhaften Signalverläufe deutlich. Beginnt ein der Tri-State-Treiberanordnung 1 zugeordneter Teilnehmer mit dem Senden von Daten (Zeitpunkt t_{START}), so erkennt der Komparator 5 den Anfang der Sendung (Zeitpunkt t_{A}) und aktiviert den Ausgangstreiber 8 mit U_{EN1}="H". Der Ausgangstreiber 8 ist jetzt aktiv und fängt an zu senden. Zu Zeitpunkten t₁ ... t_{N-1} treten kurze Signalimpulse U_{F} auf, welche auf Grund der Zeitkonstante des Glättungsfilters 6 ausgeblendet werden, so dass das Freigabesignal U_{EN1} konstant auf dem hohen Pegel "H" bleibt. Wie bereits erwähnt worden ist, kann die Zeitdauer T_{HL} bzw. T_{LH} dieser kurzen Impulse zwischen 5 ns und 10 ns liegen, so dass die Zeitkonstante T_{F} des Glättungsfilters 6 auf einen Wert zwischen 50 ns und 100 ns eingestellt werden sollte, um ein sicheres Ausblenden dieser kurzen Impulse zu gewährleisten. Bei dem in Figur 3 dargestellten Beispiel wird davon ausgegangen, dass zum Zeitpunkt t_{N} das Senden der Daten beendet wird, so dass nach Ablauf der Zeitkonstante T_{F} des Glättungsfilters 6, d.h. zum Zeitpunkt t_{STOP}=t_{N}+T_{F}, der Ausgangstreiber 8 durch Setzen des Freigabesignals U_{EN1}="L" deaktiviert wird.

Die in Figur 1 gezeigte Tri-State-Treiberanordnung 1 kann beispielsweise in einer potentialgetrennten RS-485-Schnittstelle verwendet werden, wobei auf Grund der Tatsache, dass zum Senden von Informationen und zum Aktivieren/Deaktivieren des Ausgangstreibers 8 lediglich ein Kanal benötigt wird, die bei einer Integration in ein Gehäuse erforderliche Siliziumfläche sowie der entsprechende Bondaufwand reduziert werden kann. Dabei kann die Tri-State-Treiberanordnung 1 bzw. die RS-485-Schnittstelle in Form eines neuartigen Bausteins in einem Standard-Gehäuse (beispielsweise in einem SO-8- oder einem DIP-8-Gehäuse) angeboten werden.

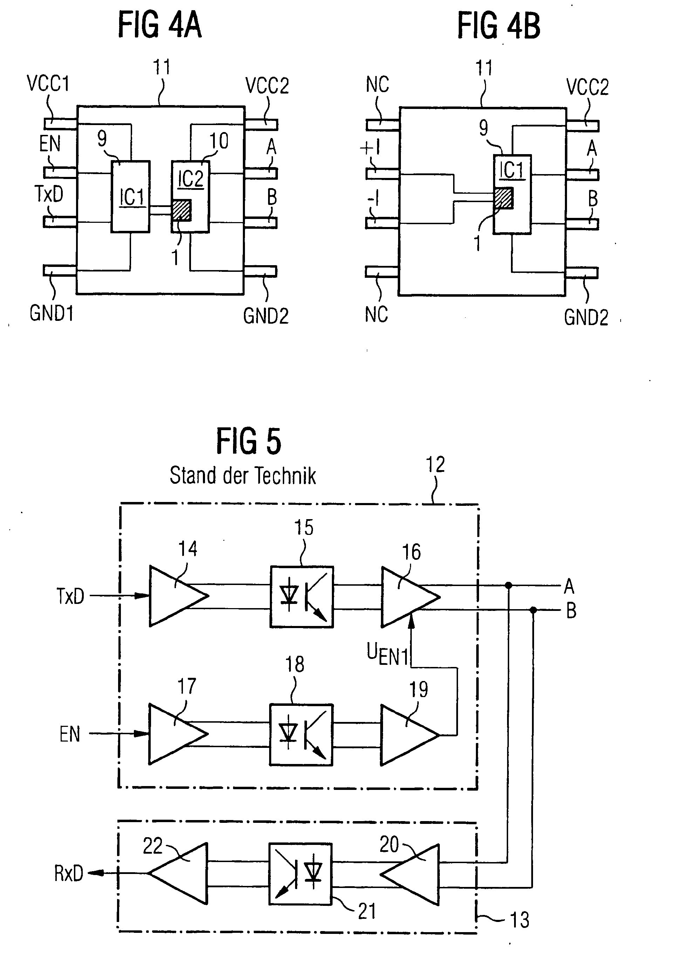

In Figur 4A ist ein Beispiel für eine Zwei-Chip-Lösung dargestellt, wobei zwei Chips 9, 10 (IC1, IC2) in einem gemeinsamen Gehäuse untergebracht sind und der erste Chip 9 zur Signalaufbereitung dient, während der zweite Chip 10 die erfindungsgemäße Tri-State-Treiberanordnung 1 beinhaltet. Die in Figur 4A gezeigte Ausgestaltung mit zwei separaten Chips 9, 10 erfordert zwei separate Versorgungsspannungsanschlüsse VCC1, VCC2 und zwei separate Masseanschlüsse GND1, GND2. Des Weiteren ist für den Chip 9 ein Eingang TxD zum Zuführen von Sendedaten bzw. zum Zuführen eines Sendesignals und ein Freigabeeingang EN vorgesehen. Dem Chip 10 sind hingegen die auch in Figur 1 gezeigten Ausgänge A, B zugeordnet.

In Figur 4B ist ein Beispiel für eine Ein-Chip-Lösung dargestellt, wobei bei dieser Ausgestaltung lediglich ein Versorgungsspannungsanschluss VCC2 und ein Masseanschluss GND2 benötigt wird. Die zum Zuführen des Eingangsstroms der Tri-State-Treiberanordnung 1 benötigten Anschlüsse sind mit +I bzw. -I bezeichnet. Des Weiteren sind wiederum die Signalausgänge A, B vorgesehen. Die übrigen Anschlusspins sind nicht belegt und mit NC bezeichnet.

## Patentansprüche

1. Tri-State-Treiberanordnung,
mit einem Koppler (2) zur potentialgetrennten Signalübertragung zwischen einem Eingang und einem Ausgang der Tri-State-Treiberanordnung (1),
mit einem mit dem Ausgang gekoppelten Ausgangstreiber (8), und
mit Steuermitteln (4 - 7) zur Ansteuerung des Ausgangstreibers (8), um diesen zum Senden von Daten in einen ersten oder zweiten Zustand und zum Deaktivieren der Tri-State-Treiberanordnung in einen dritten Zustand zu schalten,
**dadurch gekennzeichnet,**
**dass** der Koppler (2) ein Magnetkoppler ist, und
**dass** die Steuermittel (4 - 7) derart ausgestaltet sind, dass sie den Ausgangstreiber (8) in den dritten Zustand schalten, falls eine von dem Magnetkoppler (2) gelieferte Ausgangsspannung (U_{OUT}) in einem durch einen ersten Grenzwert (-U_{TH}) und einen zweiten Grenzwert (+U_{TH}) definierten Bereich liegt.

2. Tri-State-Treiberanordnung nach Anspruch 1,
**dadurch gekennzeichnet,**
**dass** der Magnetkoppler (2) durch einen auf Grundlage des "Giant Magnet Resistor" GMR-Effekts arbeitenden Sensor gebildet ist.

3. Tri-State-Treiberanordnung nach Anspruch 1 oder 2,
**dadurch gekennzeichnet,**
**dass** die Steuermittel (4 - 7) derart ausgestaltet sind, dass sie eine von dem Magnetkoppler (2) gelieferte Ausgangsspannung (U_{OUT}) auswerten, um davon abhängig den Ausgangstreiber (8) in den dritten Zustand zu schalten.

4. Tri-State-Treiberanordnung nach einem der vorhergehenden Ansprüche,
**dadurch gekennzeichnet,**
**dass** der Magnetkoppler (2) derart ausgestaltet ist, dass er einen dem Eingang der Tri-State-Treiberanordnung (1) zugeführten Eingangsstrom (I_{IN}) in eine entsprechende Ausgangsspannung (U_{OUT}) umsetzt.

5. Tri-State-Treiberanordnung nach einem der vorhergehenden Ansprüche,
**dadurch gekennzeichnet,**
**dass** die Steuermittel einen Komparator (5) umfassen, welcher in Abhängigkeit von der Ausgangsspannung (U_{OUT}) des Magnetkopplers (2) ein Steuersignal (U_{F}) zur Ansteuerung des Ausgangstreibers (8) erzeugt, wobei das Steuersignal (U_{F}) einen den Ausgangstreiber (8) aktivierenden ersten Wert annimmt, falls die Ausgangsspannung (U_{OUT}) des Magnetkopplers (2) außerhalb des durch den ersten und zweiten Grenzwert (-U_{TH}, +U_{TH}) definierten Bereichs liegt, während das Steuersignal (U_{F}) einen den Ausgangstreiber (8) deaktivierenden und in den dritten Zustand schaltenden zweiten Wert annimmt, falls die Ausgangsspannung (U_{OUT}) des Magnetkopplers (2) innerhalb des durch den ersten und zweiten Grenzwert (-U_{TH}, +U_{TH}) definierten Bereichs liegt.

6. Tri-State-Treiberanordnung nach Anspruch 5,
**dadurch gekennzeichnet, dass** das von dem Komparator (5) erzeugte Steuersignal (U_{F}) über einen Glättungsfilter (6) dem Ausgangstreiber (8) zugeführt ist.

7. Tri-State-Treiberanordnung nach einem der vorhergehenden Ansprüche,
**dadurch gekennzeichnet,**
**dass** die Steuermittel einen weiteren Komparator (4) umfassen, welche in Abhängigkeit von der Ausgangsspannung (U_{OUT}) des Magnetkopplers (2) zum Senden von Daten eine Eingangsspannung (U_{LT}) des Ausgangstreibers (8) auf einen ersten oder zweiten Wert setzt.

8. Tri-State-Treiberanordnung nach Anspruch 7,
**dadurch gekennzeichnet,**
**dass** der weitere Komparator (4) die Eingangsspannung (U_{LT}) des Ausgangstreibers (8) auf den ersten bzw. zweiten Wert setzt, falls die Ausgangsspannung (U_{OUT}) des Magnetkopplers (2) größer als ein dritter Grenzwert (+U_{H}) bzw. kleiner als ein vierter Grenzwert (-U_{H}) ist.

9. Tri-State-Treiberanordnung nach Anspruch 8,
**dadurch gekennzeichnet, dass** der erste Grenzwert (-U_{TH}) kleiner als der vierte Grenzwert (-U_{H}) und der dritte Grenzwert (+U_{H}) kleiner als der zweite Grenzwert (+U_{TH}) ist.

10. Tri-State-Treiberanordnung nach einem der vorhergehenden Ansprüche,
**dadurch gekennzeichnet, dass** der Magnetkoppler (2) eine lineare Eingangsstrom/Ausgangsspannungskennlinie aufweist.

11. Tri-State-Schnittstelle zur Anbindung eines Teilnehmers an eine Busleitung,
mit einer Tri-State-Treiberanordnung (1) nach einem der vorhergehenden Ansprüche, wobei die Tri-State-Treiberanordnung eingangsseitig über den Koppler (2) mit dem Teilnehmer und ausgangsseitig über den Ausgangstreiber (8) mit der Busleitung (A, B) zu verbinden ist.

12. Tri-State-Schnittstelle nach Anspruch 11,
**dadurch gekennzeichnet,**
**dass** die Tri-State-Schnittstelle als RS-485-Schnittstelle ausgestaltet ist.

## Claims

1. Tri-state driver arrangement,
with a coupler (2) for the potentially isolated transmission of signals between the input and the output of the tri-state driver arrangement (1),
with an output driver (8) coupled to the output, and
with control means (4-7) for controlling the output driver (8) in order to switch this to a first or second state for transmitting data and to a third state for deactivating the tri-state driver arrangement,
**characterized in that**
the coupler (2) is a magnetic coupler, and
the control means (4-7) are arranged in such a way that they switch the output driver (8) to the third state when an output voltage (U_{OUT}) supplied by the magnetic coupler (2) lies within a range defined by a first threshold value (-U_{TH}) and a second threshold value (+U_{TH}).

2. Tri-state driver arrangement according to claim 1,
**characterized in that**
the magnetic coupler (2) is formed by a sensor which works on the principle of the "Giant Magnet Resistor" GMR effect.

3. Tri-state driver arrangement according to claim 1 or claim 2,
**characterized in that**
the control means (4-7) are arranged in such a way that they evaluate an output voltage (U_{OUT}) supplied by the magnetic coupler (2), in order to switch the output driver (8) to the third state depending on this.

4. Tri-state driver arrangement according to any one of the preceding claims,
**characterized in that**
the magnetic coupler (2) is arranged in such a way that it converts an input current (I_{IN}) fed to the input of the tri-state driver arrangement (1) into a corresponding output voltage (U_{OUT}).

5. Tri-state driver arrangement according to any one of the preceding claims,
**characterized in that**
the control means comprise a comparator (5), which produces a control signal (U_{F}) dependent upon the output voltage (U_{OUT}) of the magnetic coupler (2) for controlling the output driver (8), whereby the control signal (U_{F}) assumes a first value activating the output driver (8) if the output voltage (U_{OUT}) of the magnetic coupler (2) lies outside the range defined by the first and second threshold values (-U_{TH}, +U_{TH}), whereas the control signal (U_{F}) assumes a second value deactivating the output driver (8) and switching it to the third state if the output voltage (U_{OUT}) of the magnetic coupler (2) lies within the range defined by the first and second threshold values (-U_{TH}, +U_{TH}).

6. Tri-state driver arrangement according to claim 5,
**characterized in that**
the control signal (U_{F}) produced by the comparator (5) is fed to the output driver (8) via a smoothing filter (6).

7. Tri-state driver arrangement according to any one of the preceding claims,
**characterized in that**
the control means comprise a further comparator (4), which sets an input voltage (U_{LT}) of the output driver (8) to a first or second value for transmitting data depending upon the output voltage (U_{OUT}) of the magnetic coupler (2).

8. Tri-state driver arrangement according to claim 7,
**characterized in that**
the further comparator (4) sets the input voltage (U_{LT}) of the output driver (8) to the first or second value, respectively, if the output voltage (U_{OUT}) of the magnetic coupler (2) is larger than a third threshold value (+U_{H}) or less than a fourth threshold value (-U_{H}), respectively.

9. Tri-state driver arrangement according to claim 8,
**characterized in that**
the first threshold value (-U_{TH}) is smaller than the fourth threshold value (-U_{H}) and the third threshold value (+U_{H}) is smaller than the second threshold value (+U_{TH}).

10. Tri-state driver arrangement according to any one of the preceding claims,
**characterized in that**
the magnetic coupler (2) has a linear input current/output voltage characteristic.

11. Tri-state interface for connecting a subscriber to a bus line,
with a tri-state driver arrangement (1) according to any one of the preceding claims, whereby an input side of the tri-state driver arrangement (1) is to be connected to the subscriber via the magnetic coupler (2), and whereby an output side of the tri-state driver arrangement (1) is to be connected to the bus line (A, B) via the output driver (8).

12. Tri-state interface according to claim 11,
**characterized in that**
the tri-state interface is arranged as an RS-485 interface.

## Revendications

1. Circuit d'attaque à trois états,
- avec un coupleur (2) pour la transmission de signaux séparée du potentiel entre une entrée et une sortie du circuit d'attaque à trois états (1),
- avec un circuit de puissance de sortie (8) couplé avec la sortie, et
- avec des moyens de commande (4 - 7) pour la commande du circuit de puissance de sortie (8), pour commuter celui-ci vers un premier ou vers un deuxième état pour l'émission de données et vers un troisième état pour la désactivation du circuit d'attaque à trois états,
**caractérisé:**
- **en ce que** le coupleur (2) est un coupleur magnétique, et
- **en ce que** les moyens de commande (4 - 7) sont réalisés de manière à commuter le circuit de puissance de sortie (8) vers le troisième état si une tension de sortie (U_{OUT}) livrée par le coupleur magnétique (2) est comprise dans une plage définie par une première valeur limite (-U_{TH}) et une deuxième valeur limite (+U_{TH}).

2. Circuit d'attaque à trois états selon la revendication 1, **caractérisé en ce que** le coupleur magnétique (2) est formé par un capteur fonctionnant suivant le principe de la magnétorésistance géante (GMR, « Giant Magnetoresistance Effect »).

3. Circuit d'attaque à trois états selon la revendication 1 ou la revendication 2, **caractérisé en ce que** les moyens de commande (4 - 7) sont réalisés de manière à évaluer une tension de sortie (U_{OUT}) livrée par le coupleur magnétique (2), pour commuter le circuit de puissance de sortie (8) vers le troisième état en fonction de celle-ci.

4. Circuit d'attaque à trois états selon l'une des revendications précédentes, **caractérisé en ce que** le coupleur magnétique (2) est réalisé de manière à convertir un courant d'entrée (I_{IN}) appliqué à l'entrée du circuit d'attaque à trois états (1) en une tension de sortie (U_{OUT}) correspondante.

5. Circuit d'attaque à trois états selon l'une des revendications précédentes, **caractérisé en ce que** les moyens de commande comprennent un comparateur (5) générant un signal de commande (U_{F}) pour la commande du circuit de puissance de sortie (8) en fonction de la tension de sortie (U_{OUT}) du coupleur magnétique (2), ledit signal de commande (U_{F}) prenant une première valeur activant le circuit de puissance de sortie (8) si la tension de sortie (U_{OUT}) du coupleur magnétique (2) est extérieure à la plage définie par la première et la deuxième valeurs limites (-U_{TH}, +U_{TH}), alors que le signal de commande (U_{F}) prend une deuxième valeur désactivant le circuit de puissance de sortie (8) et commutant vers le troisième état si la tension de sortie (U_{OUT}) du coupleur magnétique (2) est comprise dans la plage définie par la première et la deuxième valeurs limites (-U_{TH}, +U_{TH}).

6. Circuit d'attaque à trois états selon la revendication 5, **caractérisé en ce que** le signal de commande (U_{F}) généré par le comparateur (5) est adressé au circuit de puissance de sortie (8) via un filtre de lissage (6).

7. Circuit d'attaque à trois états selon l'une des revendications précédentes, **caractérisé en ce que** les moyens de commande comprennent un deuxième comparateur (4) fixant pour l'émission de données une tension d'entrée (U_{LT}) du circuit de puissance de sortie (8) à une première ou une deuxième valeur en fonction de la tension de sortie (U_{OUT}) du coupleur magnétique (2).

8. Circuit d'attaque à trois états selon la revendication 7, **caractérisé en ce que** l'autre comparateur (4) fixe la tension d'entrée(U_{LT}) du circuit de puissance de sortie (8) à la première ou la deuxième valeur si la tension de sortie (U_{OUT}) du coupleur magnétique (2) est supérieure à une troisième valeur limite (+U_{H}) ou inférieure à une quatrième valeur limite (-U_{H}).

9. Circuit d'attaque à trois états selon la revendication 8, **caractérisé en ce que** la première valeur limite (-U_{TH}) est inférieure à la quatrième valeur limite (-U_{H}), et la troisième valeur limite (+U_{H}) inférieure à la deuxième valeur limite (+U_{TH}).

10. Circuit d'attaque à trois états selon l'une des revendications précédentes, **caractérisé en ce que** le coupleur magnétique (2) présente une caractéristique linéaire de courant d'entrée/tension de sortie.

11. Interface à trois états pour la connexion d'un client à une barre bus, avec un circuit d'attaque à trois états (1) selon l'une des revendications précédentes, ledit circuit d'attaque à trois états étant à raccorder au client par le coupleur (2) côté entrée et à la barre bus (A, B) par le circuit de puissance de sortie (8) côté sortie.

12. Interface à trois états selon la revendication 11, **caractérisée en ce que** ladite interface à trois états est réalisée comme interface RS-485.
